# EUROPEAN PATENT APPLICATION

(11) **EP 4 462 109 A1**
(43) Date of publication of application: **13.11.2024**
(21) Application number: 23172431.1
(22) Date of filing: 09.05.2023
(51) Int. Cl.: G01N 23/2251

(54) **METHOD FOR CONFIRMING AN IONIZATION EDGE WITHIN A MEASURED EELS SPECTRUM AND FINDING ITS LOCATION**

(71) Applicant: FEI COMPANY, Hillsboro, OR 97124 (US)
(72) Inventor: VAN DEN BROEK, Wouter René J., 3543 GE Utrecht (NL); VANROMPAY, Hans Irma Stefaan, 2610 Wilrijk (BE)
(74) Representative: Janssen, Francis-Paul

(57) **Abstract**

The present invention provides a method for confirming an ionization edge within a measured EELS spectrum. The method involves providing a measured EELS spectrum containing an ionization edge and a numerical model that outputs simulated EELS spectra with the location of an ionization edge as an input parameter. The numerical model is fitted to the measured EELS spectrum, and a fitted location of the ionization edge is provided. A statistical test is used to confirm the ionization edge as a true ionization edge if it passes a statistical threshold value. The method can be used in a variety of applications, including materials science, chemistry, and physics, to improve the accuracy of EELS spectrum analysis.

## Description

The invention relates to a method for determining a location of an ionization edge within a measured Electron Energy Loss Spectroscopy (EELS) spectrum, comprising the steps of providing a measured EELS spectrum containing an ionization edge and determining the ionization edge.

Electron Energy Loss Spectroscopy is a powerful technique in electron microscopy used to study the electronic properties of materials at the nanoscale. It involves bombarding a sample with a beam of high-energy electrons and measuring the energy loss of the electrons that are scattered by the sample. The energy loss provides information about the elemental composition of the sample, and about the electronic structure and bonding of the atoms in the sample, as well as the optical and magnetic properties of the material.

EELS can be performed in both Transmission Electron Microscopy (TEM) and Scanning Transmission Electron Microscopy (STEM) modes. In TEM mode, a thin sample is illuminated by an electron beam, and the transmitted electrons are analyzed by a spectrometer to measure the energy loss. In STEM mode, a focused electron beam is scanned over a sample, and the scattered electrons are collected by a detector to generate an EELS spectrum at each pixel.

EELS has a wide range of applications in materials science, physics, chemistry, and biology. It can be used to study the properties of nanomaterials, such as nanoparticles, quantum dots, and nanowires, as well as complex materials, such as catalysts, semiconductors, and superconductors. EELS can also be used to study biological samples, such as cells and tissues, to investigate the elemental composition and chemical bonding of biological molecules.

In EELS, the energy loss spectrum provides information about the elemental composition and electronic structure of the sample, and the ionization edges are the most prominent features in the spectrum. These edges correspond to the energy required to remove an electron from a specific atomic orbital in the sample, and they are characteristic of the elemental composition and chemical environment of the material.

The most commonly studied ionization edges in EELS are the K, L, and M edges, which correspond to the ionization of the 1s, 2s-2p, and 3s-3p-3d orbitals, respectively. The position and intensity of these edges depend on the atomic number of the element and its chemical bonding environment.

The fine structure of the edges is also important in EELS analysis, as it provides information about the electronic states of the sample. For example, post-edge features in the spectrum correspond to the transitions between the ground state and excited states of the sample. These features can be used to study the local electronic structure and bonding of the material, such as the oxidation state of a metal atom or the coordination of a ligand around a metal center. Overall, the ionization edges in EELS provide a wealth of information about the electronic properties of materials and are a valuable tool in materials science research.

Determining an ionization edge in an EELS spectrum may generally involve several steps. Firstly, the raw spectrum is acquired by measuring the energy loss of high-energy electrons that pass through the sample. Then, the background is subtracted from the spectrum.

Next, the edge position is determined by identifying the sharp increase in intensity that corresponds to the ionization energy of a specific atomic orbital. This can be done by visually inspecting the spectrum or by fitting the data to a theoretical model aftermanually identifying the edge. The position of the edge is typically reported in electron volts (eV). To improve the accuracy of the analysis, multiple spectra may be acquired from different areas of the sample, and the data can be averaged to reduce the effects of local variations and the effects of statistical noise.

In practice, researchers have developed various methods for determining the location of an ionization edge within a measured EELS spectrum. In one approach a numerical model for the core-loss EELS spectrum is used. A typical core-loss EELS spectrum exhibits a strong decaying background on which the ionization edges are superposed, and that is commonly modelled as a power-law, *AE^{-r}*, with E the energy-loss. One approach involves using fitting techniques based on a first-order or second-order derivative of the measured EELS spectrum, where maxima in the first or second order derivatives surpassing a user-determined threshold are associated with edge onsets. This technique is hampered by the heavy noise customarily observed in EELS, which blurs the distinction between mere noise and actual details. A further problem in this is the fine structure in the edges, which can be of the same magnitude (or even larger) as the underlying atomic edge. One technique to overcome these issues is by pre-filtering the spectrum. Both the threshold and the properties of the pre-filter need to be set by the user, and these parameters can vary greatly among different spectra.

The localization of ionization edges in EELS can be affected by various sources of noise, drift, interference and by chemical shifts. This can lead to misidentification of the edge position and errors in the interpretation of the spectra. Additionally, edge localization relies heavily on user input, requiring substantial user expertise.

It is an object of the invention to provide an improved method of determining a location of an ionization edge within a measured EELS spectrum.

To this end, the invention provides a method for determining a location of an ionization edge within a measured EELS spectrum according to claim 1. The method as described herein comprises the steps of:
- providing a measured EELS spectrum containing an ionization edge;
- providing a numerical model for outputting simulated EELS spectra, said numerical model having at least a location of an ionization edge as an input parameter; and
- fitting said numerical model to said measured EELS spectrum and providing a fitted location of the ionization edge.

Providing a numerical model for outputting simulated EELS spectra with a location of an ionization edge as an input parameter offers a powerful advantage in accurately determining the ionization edge that best fits the experimental data. This is particularly true when a plurality of ionization edges are used as an input parameter, for identifying a single ionization edge.

As defined herein, the method comprises the step of using a statistical test and confirming the ionization edge as a true ionization edge if the statistical test passes a statistical threshold value. In other words, the statistical test is used to confirm the existence of the ionization edge. Additionally, the method may comprise the step of rejecting said ionization edge as a true ionization edge if the statistical test fails the statistical threshold value. Using a statistical test to confirm the ionization edge as a true ionization edge is particularly useful in cases where the ionization edge is close to noise or other spectral features. It may be used to confirm the existence of a true ionization edge if the statistical test passes a threshold value, and offers a significant advantage in materials analysis. By applying a statistical test with a corresponding threshold, the user may set a trade-off between false positives and false negatives. This ensures accurate characterization of the sample's material properties and electronic structure. Additionally, the use of statistical tests provides a more rigorous and objective approach to data analysis, reducing the potential for human error and bias. Overall, the use of statistical tests to confirm the existence of the ionization edge as a true ionization edge offers a robust and reliable method for materials analysis, leading to a better understanding of materials and their behavior under different conditions. By applying a statistical test, the researcher can confirm the existence of a true ionization edge, thereby ensuring accurate characterization of the sample's material properties.

The statistical threshold value may comprise a measure for the height of the curve at the ionization edge relative to the background signal level. This ensures that the ionization edge is confirmed only if it is above the threshold value, which in this embodiment is chosen to be significantly above the background noise level. It will be clear to those skilled in the art that many principles exist for setting a statistical threshold value that corresponds to a height of the curve at the ionization edge relative to the background signal level. Statistical tests that may be used to determine ionization edges in EELS include derivative and integrated based methods, which involve calculating the first derivative or integral of the spectrum and identifying inflection points or changes in slope. In one embodiment, the statistical threshold value is determined by computing the integrated intensity of the background extrapolated below the edge, and comparing it to the integrated intensity of the measurements in the same edge region. With the aid of error-propagation it is decided if the difference is significant. The choice of statistical test and threshold value depends on the specific characteristics of the spectrum and the level of accuracy required for the analysis.

The method as provided requires a lot less user input, and by removing this need also less-experienced operators are served in correctly identifying ionization edges in EELS.

With this, the object is achieved. Advantageous embodiments will be described below.

In an embodiment, the method comprises the step of providing a plurality of ionization edges as an input parameter.

In one embodiment, the plurality of ionization edges may be used to identify a plurality of different ionization edges. For each of the plurality of ionization edges, the statistical threshold value may be used to confirm the ionization edge as a true ionization edge if a statistical threshold value is exceeded.

In another embodiment, the step of providing a plurality of ionization edges as an input parameter is used for identifying only a single ionization edge. Providing a plurality of ionization edges as an input parameter is a powerful tool for identifying a single ionization edge in a material's spectrum. This approach allows for the comparison of different potential ionization edges to more accurately determine a single true ionization edge. The statistical test and threshold value as defined herein can then be used to determine whether an ionization edge actually exists. In case multiple potential ionization edges showcase the desired statistical threshold value, it is possible to select the best one, based on the maximum value of the statistical test.

In an embodiment, the method comprises the step of dividing the measured EELS spectrum into a plurality of subregions. Dividing the measured EELS spectrum into a plurality of subregions allows for a more accurate identification of true ionization edges. By dividing the spectrum into smaller subregions, the noise and interference from nearby edges can be reduced, resulting in a clearer and more accurate identification of the desired edge. This approach also allows for the identification of multiple edges within a single spectrum, which can be useful in determining the composition and structure of the material being analyzed. Additionally, this technique can be used to better understand the underlying physics of the material, as well as to optimize the performance of the electron microscope.

In an embodiment, at least one of the subregions spans a maximum of 750 eV, in particular 500 eV and more in particular 250 eV.

In an embodiment, the method comprises the step of providing a plurality of ionization edges within the subregion as an input parameter, and identifying a single ionization edge within that subregion. As indicated before, this allows a plurality of candidates to be tested for a single ionization edge. The method may comprise the step of selecting a single one of the plurality of candidates (i.e., plurality of ionization edges within the subregion) that provides the best match of the single ionization edge within that subregion.

In an embodiment, the method comprises the step of using said fitted location and the measured EELS spectrum, wherein said statistical test and/or statistical threshold value is based on one or more of the following: the surplus value of the EELS spectrum at said fitted location with respect to a base background value, a derivative method and an integrated method. The use of surplus value, derivative method and/or integrated method as the basis for statistical tests and threshold values allows for a more precise and accurate identification of the true existence of an ionization edge in the EELS spectrum.

The surplus value method compares the value of the EELS spectrum at the fitted location to the background value, thus providing a clear indication of the presence of an ionization edge. The derivative method calculates a (first and/or second) derivative of the EELS spectrum and uses the resulting value to determine the sharpness of the peak, which can help confirm the presence of an ionization edge. The integrated method involves calculating the area under the EELS spectrum around the fitted location, which provides a measure of the intensity of the peak and can help confirm the presence of an ionization edge. All methods, in a way, use a statistical threshold value that comprises a measure for the height of the curve at the ionization edge relative to the background signal level.

By using one or more of these statistical tests, a more objective and quantitative approach to identifying ionization edges in the EELS spectrum is obtained, reducing the likelihood of subjective interpretations and errors. By using a combination of these methods as the basis for statistical tests and threshold values, the accuracy and reliability of the identification process can be improved even further.

In an embodiment, the method comprises the step of setting, by a user, the statistical threshold value. This allows the user to provide some input.

According to an aspect, a device is provided with which the method can be performed. The device comprises a processing unit that is arranged for performing one or more steps of the method as defined herein. The device is arranged for determining a location of an ionization edge within a measured EELS spectrum. The processing unit is arranged for receiving a measured EELS spectrum containing an ionization edge. The processing unit is equipped with a numerical model for outputting simulated EELS spectra, said numerical model having at least a location of an ionization edge as an input parameter. The processing unit is arranged for fitting said numerical model to said measured EELS spectrum and providing a fitted location of the ionization edge. Said processing unit is arranged for performing a statistical test and confirming said fitted ionization edge as a true ionization edge if the statistical test passes a statistical threshold value. Said processing unit is arranged for outputting said fitted location of the ionization edge as a true ionization edge if the statistical test passes a statistical threshold value.

The method and device as disclosed herein will now be elucidated in more detail on the basis of exemplary embodiments and the accompanying schematic drawings, in which:
Fig. 1 shows a longitudinal cross-sectional view of a charged-particle microscope;
Fig. 2 shows an enlarged longitudinal cross-sectional view of a spectroscopic apparatus;
Fig. 3 shows an example of an EELS spectrum;
Fig. 4 schematically shows an embodiment of the method as disclosed herein;
Fig. 5 shows a subregion of an EELS spectrum to which the method as disclosed herein is applied.

In the Figures, where pertinent, corresponding parts are indicated using corresponding reference symbols. It should be noted that, in general, the Figures are not to scale.

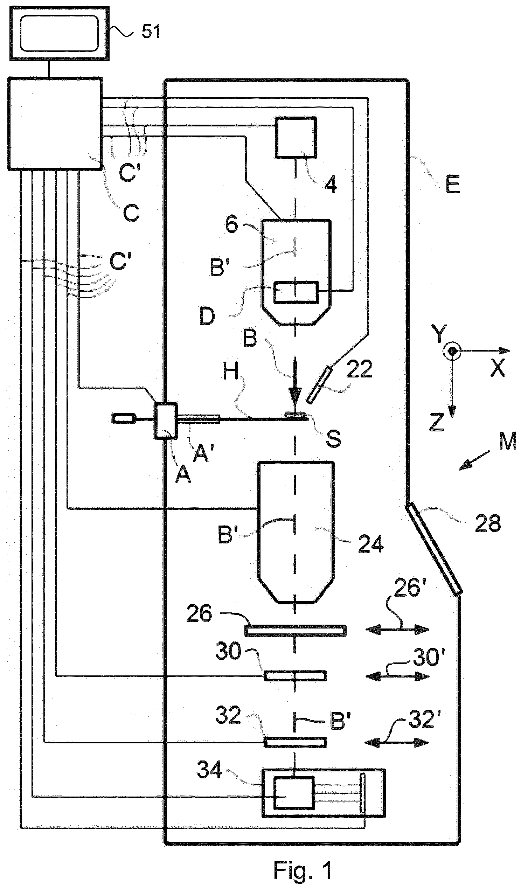

Fig. 1 is a highly schematic depiction of an embodiment of a transmission charged particle microscope, which, in this case, is a TEM/STEM (though, in the context of the present disclosure, it could just as validly include additional charged particle sources, such as ion-based and/or proton based, , for example). In Fig. 1, within a vacuum enclosure E, an electron source 4 (such as a Schottky emitter, for example) produces a beam (B) of electrons that traverse an electron-optical illuminator 6, serving to direct/focus them onto a chosen part of a sample S (which may, for example, be (locally) thinned/planarized). This illuminator 6 has an electron-optical axis B', and will generally comprise a variety of electrostatic / magnetic lenses, (scan) deflector(s) D, correctors (such as stigmators), *etc.*; typically, it can also comprise a condenser system (the whole of item 6 is sometimes referred to as "a condenser system").

The sample S is held on a sample holder H. As here illustrated, part of this holder H (inside enclosure E) is mounted in a cradle A' that can be positioned/moved in multiple degrees of freedom by a positioning device (stage) A; for example, the cradle A' may (*inter alia*) be displaceable in the X, Y and Z directions (see the depicted Cartesian coordinate system), and may be rotated about a longitudinal axis parallel to X. Such movement allows different parts of the sample S to be irradiated / imaged / inspected by the electron beam traveling along axis B' (and/or allows scanning motion to be performed as an alternative to beam scanning [using deflector(s) D], and/or allows selected parts of the sample S to be machined by a (non-depicted) focused ion beam, for example).

The (focused) electron beam B traveling along axis B' will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of detector 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, emerge (emanate) from it and continue to propagate (substantially, though generally with some deflection/scattering) along axis B'. Such a transmitted electron flux enters an imaging system (combined objective/projection lens) 24, which will generally comprise a variety of electrostatic / magnetic lenses, deflectors, correctors (such as stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the sample S will be formed by imaging system 24 on screen 26, and this may be viewed through viewing port 28 located in a suitable part of a wall of enclosure E. The retraction mechanism for screen 26 may, for example, be mechanical and/or electrical in nature, and is not depicted here.

As an alternative to viewing an image on screen 26, one can instead make use of the fact that the depth of focus of the electron flux emerging from imaging system 24 is generally quite large (*e.g*., of the order of 1 meter). Consequently, various types of sensing device / analysis apparatus can be used downstream of screen 26, such as:
- TEM camera 30. At camera 30, the electron flux can form a static image (or diffractogram) that can be processed by controller C and displayed on a display device (not depicted), such as a flat panel display, for example. When not required, camera 30 can be retracted/withdrawn (as schematically indicated by arrows 30') so as to get it out of the way of axis B'.
- STEM recorder 32. An output from recorder 32 can be recorded as a function of (X,Y) scanning position of the beam B on the sample S, and an image can be constructed that is a "map" of output from recorder 32 as a function of X,Y. Recorder 32 can comprise a single pixel with a diameter of *e.g*. 20 mm, as opposed to the matrix of pixels characteristically present in camera 30. Moreover, recorder 32 will generally have a much higher acquisition rate (*e.g*., 10⁶ points per second) than camera 30 (*e.g*., 10² images per second). Once again, when not required, recorder 32 can be retracted/withdrawn (as schematically indicated by arrows 32') so as to get it out of the way of axis B' (although such retraction would not be a necessity in the case of a donut-shaped annular dark field recorder 32, for example; in such a recorder, a central hole would allow beam passage when the recorder was not in use).
- As an alternative to imaging using camera 30 or recorder 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

Note that the controller (which may be a combined controller and processor) C is connected to various illustrated components via control lines (buses) C'. Controller can be connected to a computer screen 51, which may be provided with a user interface (Ul). This controller C can provide a variety of functions, such as synchronizing actions, providing setpoints, processing signals, performing calculations, and displaying messages/information on a display device (not depicted). It will be understood that the (schematically depicted) controller C may be (partially) inside or outside the enclosure E, and may have a unitary or composite structure, as desired. The skilled artisan will understand that the interior of the enclosure E does not have to be kept at a strict vacuum; for example, in a so-called "Environmental TEM/STEM", a background atmosphere of a given gas is deliberately introduced/maintained within the enclosure E. The skilled artisan will also understand that, in practice, it may be advantageous to confine the volume of enclosure E so that, where possible, it essentially hugs the axis B', taking the form of a small tube (*e.g*. of the order of 1 cm in diameter) through which the employed electron beam passes, but widening out to accommodate structures such as the source 4, sample holder H, screen 26, camera 30, recorder 32, spectroscopic apparatus 34, *etc.*

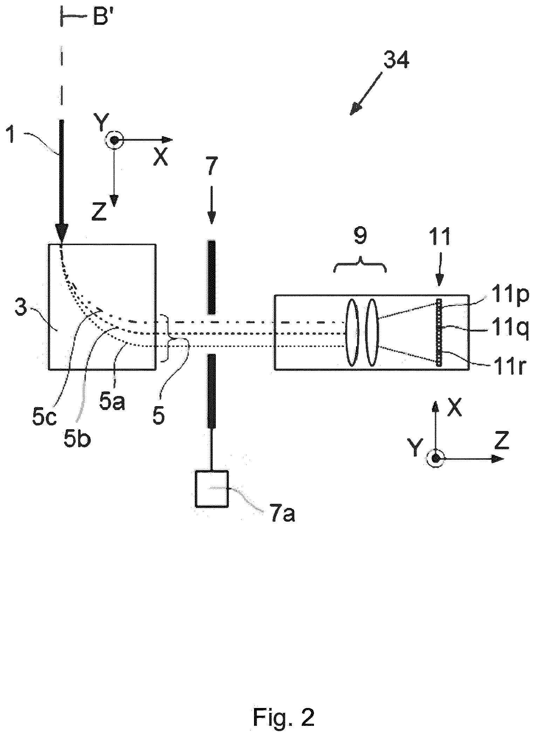

Turning now to Fig. 2, this shows an enlarged and more detailed view of an embodiment of the spectroscopic apparatus 34 in Fig. 1. Here, a flux 1 of electrons (which has passed through sample S and imaging system 24) is shown propagating along electron-optical axis B'. This flux 1 enters a dispersing device 3 ("electron prism"), where it is dispersed (fanned out) into an energy-resolved (energy-differentiated) array 5 of spectral sub-beams (schematically indicated in Fig. 2 using broken lines), which are distributed along dispersion direction X; for illustration purposes, three of these sub-beams are labelled 5a, 5b and 5c in the Figure. Note in this regard that, conventionally, propagation is considered to occur along the Z direction, and the depicted Cartesian coordinate system thus "co-deflects with" the flux 1 within the dispersing device 3.

Downstream of the dispersing device 3, the array 5 of sub-beams encounters an adjustable/retractable slit (letterbox) 7, which can, for example, be used in EFTEM-mode to select/admit a given portion of the array 5 and to discard/occlude other portions thereof; to this end, the slit 7 is connected to an actuation device 7a that can be invoked to open / close / move the (opening in the) slit 7 as desired. In EELS mode, this slit 7 is usually (fully) open/ retracted. The skilled artisan will understand that the slit 7 is advantageously disposed at a location at or proximal to a dispersion plane of the spectroscopic apparatus 34; similarly, the detector 11 is also advantageously located at or proximal to such a plane. If required, it is possible to aim/shift the array 5 of spectral sub-beams falling upon the slit 7 by appropriately adjusting, for example, (an electrical signal to) the dispersing device 3 and/or a drift tube / deflector (not depicted) provided between the dispersing device 3 and slit 7, for instance.

After having traversed slit 7, the (selected portion of the) array 5 passes through post-dispersion electron optics 9, where it is magnified/focused, for example, and ultimately directed/projected onto detector 11. The detector 11 may comprise an assembly of sub-detectors arranged along dispersion direction X, with different sub-detectors being adjustable so as to have different detection sensitivities. For illustration purposes, three of these sub-detectors are labelled 11p, 11q and 11r in the Figure. Each of these sub-detectors (*e.g*., 11p, 11q, 11r) may, for example, be:
- An avalanche photodiode, or a linear array of such avalanche photodiodes extending along Y;
- A pixel (*e.g*., a 3T pixel) of a CMOS or CCD sensor, or a linear array of such pixels extending along Y.

The sensitivity of a given sub-detector (*e.g*., 11p, 11q, 11r) can be matched to suit the intensity of the portion of the array 5 that impinges upon it.

It is noted that other detector configurations for measuring EELS spectra are known to those skilled in the art and are applicable in the method as disclosed herein as well. The method is in principle not limited to the use of a specific detector.

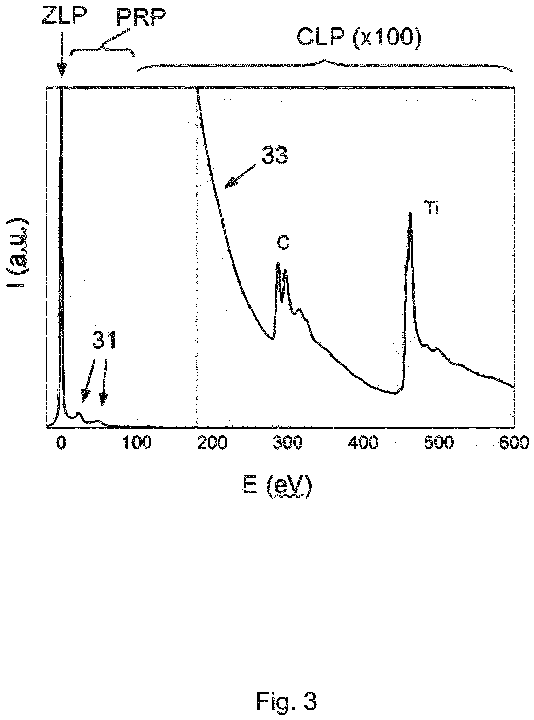

Fig. 3 shows an example of an EELS spectrum. The Figure renders intensity I (in arbitrary units, a.u.) as a function of energy-loss E (in eV) for electrons that have traversed a sample containing Carbon and Titanium. From left to right, the main features of the spectrum are:
- A Zero-Loss Peak ZLP, representing electrons that traverse the sample without undergoing inelastic scattering therein;
- A Plasmon Resonance Peak component/section PRP (sometimes referred to as a Valence Loss component), a relatively broad series of peaks/shoulders associated with single or multiple scattering of electrons on plasmons in the specimen. This typically extends from about 0 to 50 eV, although there is no strict definition of its upper limit. It is characterized by peaks/shoulders resulting from outer-shell scattering events in the sample, such as peaks 31. Note that the PRP component usually has a significantly lower intensity than the ZLP.
- A Core Loss Peak component/section CLP. This typically starts at about 50 eV (after the PRP component), although there is no strict definition of its lower limit. It is typically of such a low intensity relative to the ZLP/PRP components that, as rendered in Fig. 3, it is enlarged by a multiplication factor (e.g., 100) to improve visibility of its details. As can be seen, it contains (clusters of) peaks/shoulders that can be associated with certain chemical elements (such as C and Ti, in the current example), seated on top of a substantial background contribution 33.

The EELS spectrum shown in Fig. 3 can be measured in ways known to those skilled in the art. In a specific embodiment, use is made of the spectroscopic apparatus 34 of Fig. 2, in which:
- Sub-beam 5a comprises (part of) a ZLP spectral component, and impinges upon sub-detector 11r, which is adjusted to have a relatively low detection sensitivity;
- Sub-beam 5b comprises (part of) a PRP spectral component, and impinges upon sub-detector 11q, which is adjusted to have an intermediate-value detection sensitivity;
- Sub-beam 5c comprises (part of) a CLP spectral component, and impinges upon sub-detector 11p, which is adjusted to have a relatively high detection sensitivity.

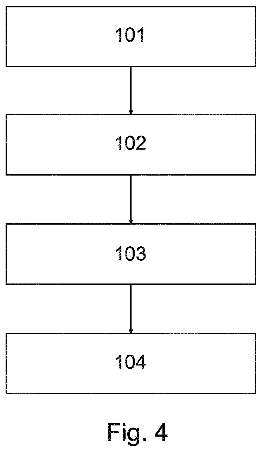

The determination of the ionization edges may comprise the following steps (Fig. 4):
- providing 101 a measured EELS spectrum containing an ionization edge;
- providing 102 a numerical model for outputting simulated EELS spectra, said numerical model having at least a location of an ionization edge as an input parameter;
- fitting 103 said numerical model to said measured EELS spectrum and providing a fitted location of the ionization edge; and
- using 104 a statistical test and confirming the existence of the ionization edge as a true ionization edge.

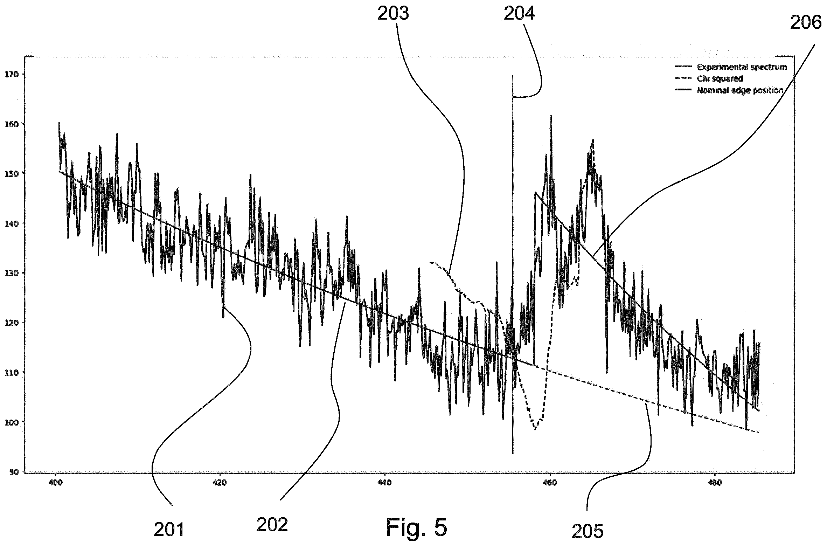

Advantages and further embodiments have been described above already. For clarification purposes, specific embodiments will be described below under reference to Fig. 5. Fig. 5 shows a part of a measured EELS spectrum, having an ionization edge. Fig. 5 shows a subregion of the entire spectrum as indicated in Fig. 3. In this embodiment, the method comprises the step of selecting a subregion of the entire spectrum. Here, the subregion spans approximately 100 eV (400 eV up to and over 480 eV). Other bandwidths of subregions may be selected as well, such as 50 eV, 75 eV and 200 eV.

Within this subregion or bandwidth, the following method can be applied. An indication of the true ionization edge may be provided. For example, it is possible that a nominal edge energy is provided, which can be based on a data base.

In the embodiment shown in Fig. 5, an energy window of a certain width is defined around the nominal edge energy. Next, a power-law is fitted to the left and to the right of each energy in the window, and the quality of the fit, for example the sum of squared differences, is registered. The true edge position is then estimated as the energy for which the fit performs best. This allows the fitting of the edge position to be relatively quick, so that it can be shown to the user relatively quickly. One option, for example, is displaying the fitted edge position on a user interface screen.

A statistical test is then devised that checks if the edge truly exists. It computes, in this embodiment, the integrated intensity of the background extrapolated below the edge, and compares it to the integrated intensity of the measurements in the same edge region. With the aid of error-propagation it is decided if the difference is significant. The noise needed as an input for this error propagation can be based on the EELS data itself, bypassing the need for good noise models.

From these two building blocks, i.e., 1) the use of the statistical test and 2) the division of the spectrum into subregions, an auto edge identification can be built. The whole spectrum is divided in subregions of about 50 eV wide, and in each region the edge tracker is ran to find a local edge onset, then the statistical test decides if the identified peak is significant.

Returning to Fig. 5, an experimental EELS spectrum 201 is shown, with a power-law 202, 206 fitted to the left part (202) and the right part (206). The goodness of fit 203 reaches a clear optimum to the right of the nominal edge onset 204. For the statistical test, the area under the extrapolated background 205 is integrated and compared to the integral of the experimental spectrum.

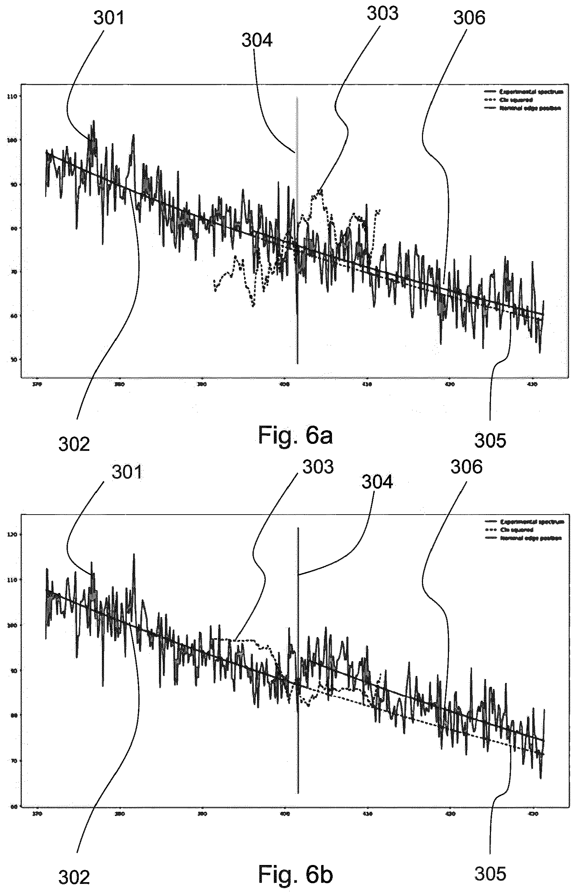

Fig. 6a-6d show different EELS spectra 301. For all spectra 301 a numerical model is used to output simulated EELS spectra having a location 304 of an ionization edge as an input parameter. The model returns a simulated spectrum 302 before the ionization edge 304 (left hand part), and a spectrum 306 after the ionization edge 304 (right hand part). In this example, a plurality of potential locations 304 for the ionization edge are input into the model, and the corresponding results are compared to the actual data 301. For each potential location 304 the goodness of fit is calculated, for example using a least-squares method. The goodness of fit is indicated with line 303. If this line reaches a minimum, then a potential ionization edge is identified. With the potential ionization edge, a statistical threshold value is used to determine whether the potential ionization edge is a true ionization edge - in other words whether there truly exists an ionization edge in the part of the data that is analyzed. For this statistical threshold value, the following method can be applied. The integrated intensity of the background extrapolated below the edge is calculated and compared to the integrated intensity of the measurements in the same edge region. With the aid of error-propagation it is decided if the difference is significant. As described above, other methods including the surplus method, derivative methods, and/or integrative methods can be used as well.

By using this method in the spectra 301 as shown in Fig. 6a-6d, it can be found that:
Fig. 6a shows a clear fail;
Fig. 6b shows a near fail;

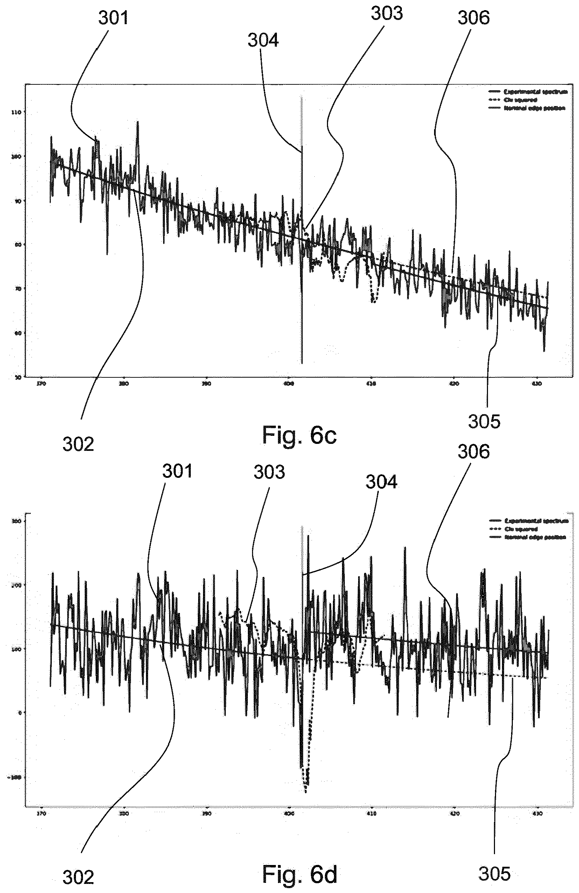

Fig. 6c shows a negative edge, which is rejected on the basis of not being physical;
Fig. 6d shows a barely passed.

Thus, even though the fit with the model was possible in all instances, the use of the statistical test confirmed only the existence of an ionization edge in the last example (Fig. 6d).

The use of a statistical threshold value allows the user to set a desired threshold value. A lower threshold value may lead to more confirmed ionization edges, whereas a higher threshold value may lead to less confirmed ionization edges. A lower threshold may lead to more false positives and less false negatives; whereas a higher threshold may lead to less false positives and more false negatives. This indicates that the preference of the user may play a role in setting the desired threshold value. It is also conceivable that the threshold value is set automatically, for example by an algorithm.

The desired protection is conferred by the appended claims.

## Claims

1. Method for confirming an ionization edge within a measured EELS spectrum, the method comprising the steps of:
- providing a measured EELS spectrum containing an ionization edge;
- providing a numerical model for outputting simulated EELS spectra, said numerical model having at least a location of
an ionization edge as an input parameter;
- fitting said numerical model to said measured EELS spectrum and providing a fitted location of the ionization edge; and
- using a statistical test for confirming the ionization edge as a true ionization edge if the statistical test passes a statistical threshold value

2. Method according to claim 1, wherein the method comprises the step of providing a plurality of ionization edges as an input parameter.

3. Method according to claim 2, wherein the step of providing a plurality of ionization edges as an input parameter is used for identifying a single ionization edge.

4. Method according to claim 1-3, comprising the step of dividing the measured EELS spectrum into a plurality of subregions.

5. Method according to claim 4, wherein at least one of the subregions spans a maximum of 750 eV, in particular 500 eV and more in particular 250 eV.

6. Method according to claim 5, comprising the step of providing a plurality of ionization edges within the subregion as an input parameter, and identifying a single ionization edge within that subregion.

7. Method according to claim 1-6, comprising the step of using said fitted location and the measured EELS spectrum, wherein said statistical test and/or statistical threshold value is based on one or more of the following: the surplus value of the EELS spectrum at said fitted location with respect to a base background value, a derivative method and an integrated method.

8. Method according to claim 1-7, wherein the method comprises the step of setting, by a user using an input device, the statistical threshold value.

9. A device for confirming an ionization edge within a measured EELS spectrum, comprising a processing unit, wherein the processing unit is arranged for:
- receiving a measured EELS spectrum containing an ionization edge;
- outputting simulated EELS spectra, using a numerical model, said numerical model having at least a location of an ionization edge as an input parameter;
- fitting said numerical model to said measured EELS spectrum and providing a fitted location of the ionization edge;
- performing a statistical test and confirming said ionization edge as a true ionization edge if the statistical test passes a statistical threshold value; and
- outputting said fitted location of the ionization edge as a true ionization edge when the statistical test has passed the statistical threshold value.
